# FASCICULE DE BREVET EUROPEEN

(11) **EP 3 798 844 B1**
(45) Date de publication et mention de la délivrance du brevet: **11.01.2023**
(21) Numéro de dépôt: 20198137.0
(22) Date de dépôt: 24.09.2020
(51) Int. Cl.: G06F 11/18, G01R 31/3185, G06F 11/16, G06F 11/267, G01R 31/3181

(54) **DÉTECTION ET CORRECTION D'ERREURS**
FEHLERERKENNUNG UND -KORREKTUR
ERROR DETECTION AND CORRECTION

(30) Priorité: 27.09.2019 FR 1910707
(43) Date de publication de la demande: 31.03.2021
(73) Titulaire: STMICROELECTRONICS SA, 92120 Montrouge (FR)
(72) Inventeur: GOMEZ GOMEZ, Ricardo, 38000 GRENOBLE (FR); CLERC, Sylvain, 38000 GRENOBLE (FR)
(74) Mandataire: Cabinet Beaumont

(56) Documents cités:
- US-A1- 2001 038 304
- US-A1- 2005 154 947
- US-A1- 2007 028 157
- US-A1- 2008 086 666
- US-A1- 2010 088 565

## Description

### Domaine technique

La présente description concerne de façon générale la détection et la correction d'erreurs dans un dispositif électronique, et plus particulièrement un procédé de détection et de correction d'erreurs par comparaison de dispositifs électroniques. La présente description concerne, de plus, un dispositif permettant de mettre en oeuvre un tel procédé de détection et de correction d'erreurs dans un dispositif électronique.

### Technique antérieure

L'utilisation, dans un système électronique, de dispositifs électroniques, comme des processeurs, des microprocesseurs, des systèmes intégrés, des mémoires, etc., est de plus en plus soumise à des contraintes de performances et de fiabilité. Pour satisfaire à certaines normes et/ou charte de qualité, ces dispositifs sont généralement couplés à des dispositifs de détection et/ou de correction d'erreurs. En effet, des erreurs de fonctionnement peuvent se présenter lors de l'exécution d'un de ces dispositifs et perturber leurs fonctionnements et/ou le fonctionnement global du système électronique les comprenant.

Plusieurs types d'erreurs, ou fautes, peuvent se produire au sein d'un dispositif électronique. A titre d'exemple, certaines erreurs (SPF, Single Point Fault) produisent directement une violation d'un objectif de sécurité. Cet objectif de sécurité est généralement basé sur une norme, par exemple la norme ISO26262 concernant les systèmes de sécurité. Ces erreurs sont facilement reconnaissables par observation du fonctionnement du dispositif et/ou du système. D'autres erreurs (LFM, Latent Fault Metric), dites erreurs latentes, ne produisent pas instantanément de dysfonctionnement, mais peuvent en produire, par exemple, ultérieurement, ou lorsqu'elles sont combinées à d'autres erreurs. Ce sont des erreurs plus difficiles à détecter, et donc à corriger, car une simple observation du fonctionnement du dispositif ou du système n'est généralement pas suffisante.

Il existe donc un besoin pour des procédés de détection et de correction d'erreurs dans les dispositifs électroniques, et des dispositifs adaptés à mettre en oeuvre ces procédés, ayant une meilleure protection des fautes, et une correction des erreurs plus rapide.

Le document US2007/0028157 divulgue un procédé de détection d'erreurs comprenant la comparaison d'au moins deux dispositifs électroniques identiques comprenant des données de test, comprenant les étapes suivantes:(a) les données de test en dernière position des deux dispositifs sont comparées; les données de test de l'étape (a) sont écrites en première position, les étapes (a) et (c) sont répétées jusqu'à ce que toutes les données de test reprennent leur place initiale.

Les documents US2005154947 et US2008086666 A1 décrivent un ensemble de bascules dont les sorties sont comparées et rebouclées dans un contexte de type test scan.

### Résumé de l'invention

Il existe un besoin pour un procédé de détection et de correction d'erreurs dans un dispositif électronique.

Il existe un besoin pour un dispositif de détection et de correction d'erreurs dans un dispositif électronique.

Il existe un besoin pour un dispositif et un procédé de détection et de correction d'erreurs indépendant de la nature du dispositif à surveiller.

Il existe un besoin pour un dispositif et un procédé de détection et de correction d'erreurs dans un dispositif électronique simple à mettre en oeuvre.

Il existe un besoin pour un dispositif et un procédé de détection et de correction d'erreurs dans un dispositif électronique ne comprenant pas de mémoire supplémentaire pour stocker les données à surveiller.

Un mode de réalisation pallie tout ou partie des inconvénients des procédés de détection et de correction d'erreurs, et des dispositifs, mettant en oeuvre un tel procédé, connus.

L'invention concerne un procédé de détection et de correction d'erreurs comprenant la comparaison d'au moins trois dispositifs identiques comprenant chacun au moins une chaîne de données de test, chaque donnée de test étant stockée dans un point de test, les points de test étant disposés dans le dispositif dès sa conception et la donnée de test stockée étant une donnée donnant une indication sur l'état du ou des composants auxquels le point de test est rattaché, le procédé comprenant comprenant les étapes suivantes :
(a) les données de test en dernière position dans ladite chaîne desdits au moins trois dispositifs sont comparées ;
(b) les autres données de test sont avancées d'une position dans leur chaîne ; et
(c) le résultat de la comparaison de l'étape est écrit en première position dans ladite chaîne,
les étapes (a), (b) et (c), et sont répétées jusqu'à ce que toutes les données de test desdites chaînes sont comparées.

Selon un mode de réalisation, les points de test sont des registres ou des bascules.

Selon un mode de réalisation, les données de test sont des mots binaires.

Selon un mode de réalisation, les données de test sont tous des mots binaires de même taille.

Selon un mode de réalisation, les données de test sont des mots binaires de taille différente.

Selon un mode de réalisation, les dispositifs comprennent au moins deux chaînes de données de test.

Selon un mode de réalisation, le procédé est un procédé de comparaison de plus de trois dispositifs électroniques identiques.

Un autre mode de réalisation prévoit un dispositif de comparaison adapté à mettre en oeuvre le procédé décrit précédemment.

Selon un mode de réalisation, le dispositif est un dispositif de comparaison d'au moins trois dispositifs électroniques identiques comprenant chacun au moins une chaîne de données de test, comprenant :
- un circuit comparateur ; et
- au moins trois boucles de rétroaction reliant chacune une sortie du circuit comparateur et une entrée d'une desdites chaînes.

Selon un mode de réalisation, chaque boucle de rétroaction relie une sortie du circuit comparateur et une entrée d'une desdites chaînes par l'intermédiaire d'un multiplexeur.

Un autre mode de réalisation prévoit un système électronique comprenant :
- au moins trois dispositifs électroniques identiques comprenant chacun au moins une chaîne de données de test ; et
- un dispositif de comparaison décrit précédemment.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 représente, de façon schématique et sous forme de blocs, un dispositif électronique ;
la figure 2 représente, de façon schématique et sous forme de blocs, un mode de réalisation d'un dispositif de détection et de correction d'erreurs dans des dispositifs électroniques du type du dispositif de la figure 1 ; et
la figure 3 est un organigramme illustrant le fonctionnement du mode de réalisation de la figure 2.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés entre eux, cela signifie que ces deux éléments peuvent être connectés ou être reliés ou couplés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près.

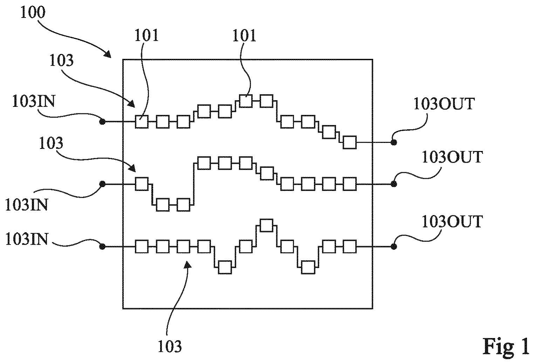

La figure 1 représente, de façon schématique et sous forme de blocs, un dispositif électronique 100. Le dispositif électronique 100 est par exemple un processeur, un microprocesseur, un système intégré, une unité de commande, une mémoire, etc.

Le dispositif électronique 100 comprend plusieurs points de test 101. Chaque point de test 101 stocke une donnée fonctionnelle, utilisée pendant la mise en oeuvre du dispositif, et appelée donnée de test pendant une phase de test. Les points de test 101 sont, par exemple, disposés dans le dispositif 100 dès sa conception, et sont chacun rattachés à un ou plusieurs modules ou composants du dispositif 100. La donnée de test stockée dans un point de test 101 est une donnée donnant une indication sur l'état d'un ou plusieurs composants auxquels le point de test 101 est rattaché. A titre d'exemple, un point de test 101 est un registre, ou une bascule. La donnée de test est, par exemple, un mot binaire codé sur N bits. A titre d'exemple, N est compris entre 1 et 64 bits, par exemple, égal à 1. A titre d'exemple, les points de test comprennent tous des mots binaires de même taille. Selon un autre exemple, certains points de test 101 comprennent des mots binaires de tailles différentes. Plus particulièrement, un point de test 101 peut comprendre un mot binaire, ou signature (MISR, Multiple Input Signature Register), reflétant l'état d'une mémoire.

Les points de test 101 sont organisés en une ou plusieurs chaînes de test 103. Chaque chaîne de test 103 comprend un noeud d'entrée 103IN et un noeud de sortie 103OUT.

Le dispositif 100 peut comprendre autant de points de test que nécessaire, organisés en autant de chaînes de test que nécessaires. Les chaînes de test 103 ont, de préférence, toutes le même nombre de points de test 101, mais peuvent, à titre de variante, avoir des nombres de points de test 101 différents. A titre d'exemple, le dispositif 100 illustré en figure 1 comprend, par exemple, trente-trois points de test 101 organisés en trois chaînes de test 103 comprenant chacune onze points de test 101.

Une phase de détection d'erreurs, ou de fautes, ou une phase de test, du dispositif 100 consiste généralement en la lecture et la comparaison de toutes les données de test stockées dans les points de test. Le nombre de points de test 101 compris dans une chaîne de test 103 influe donc sur la durée d'une phase de test. En effet, plus la chaîne de test 103 comprend des points de test 101, plus la phase de test est longue. L'organisation des points de test 101 en chaînes de test 103 peut permettre de raccourcir cette durée en permettant la lecture de plusieurs points de test 101 en parallèle.

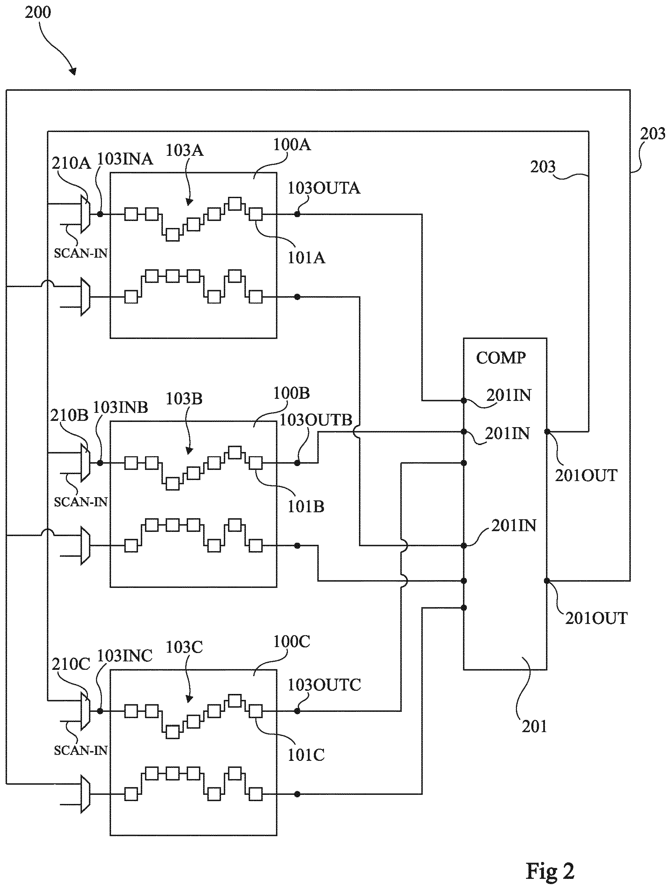

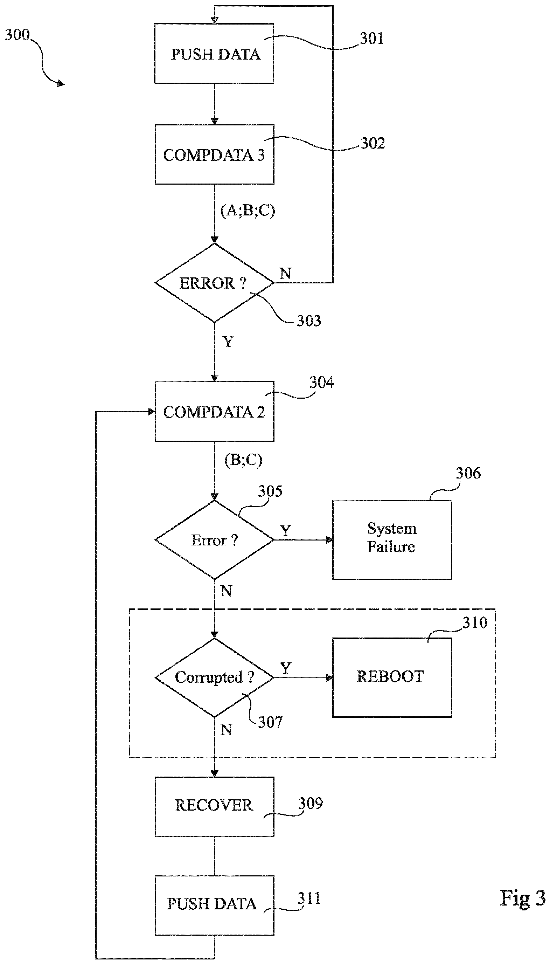

Un dispositif et un procédé de détection et de correction d'erreurs dans le dispositif 100 seront décrits en relation avec les figures 2 et 3.

La figure 2 représente, de façon schématique et sous forme de blocs, un mode de réalisation d'un dispositif 200 de détection et de correction d'erreurs par comparaison, ou dispositif de comparaison, de trois dispositifs 100A, 100B, et 100C, identiques du type du dispositif 100 décrit en relation avec la figure 1. Les dispositifs 100A, 100B, et 100C, sont, plus particulièrement, identiques dans leur structure, mais ont également mis en oeuvre les mêmes opérations, et devraient être caractérisés par des données de test identiques.

Selon un mode de réalisation, chaque dispositif 100A, respectivement 100B, 100C comprend des chaînes de test 103A, respectivement 103B, 103C, comprenant des points de test 101A, respectivement 101B, 101C. Chaque chaîne de test 103A, respectivement 103B, 103C, comprend une entrée 103INA, respectivement 103INB, 103INC, et une sortie 103OUTA, respectivement 103OUTB, 103OUTC. Les dispositifs 100A, 100B, 100C étant identiques dans leur structure, ils comprennent chacun les mêmes chaînes de test 103A, 103B, 103C. On appellera, par la suite, des chaînes de test 103A, 103B, 103C analogues des chaînes de test 103A, 103B, et 103C identiques des dispositifs 100A, 100B, et 100C comprenant les mêmes points de test 101A, 101B, et 101C et des données de test à priori identiques.

Dans le cas illustré en figure 2, chaque dispositif 100A, 100B, 100C, comprend deux chaînes de test 103A, 103B, 103C, chacune comprenant sept points de test 101A, 101B, 101C. Les dispositifs 100A, 100B et 100C comprennent alors deux jeux de chaînes de test 103A, 103B, 103C analogues.

Le dispositif de comparaison 200 comprend un circuit comparateur 201 (COMP) comprenant autant d'entrées 201IN que le nombre total de chaînes de test des dispositifs 100A, 100B, et 100C, et autant de sorties 201OUT que de chaînes de test dans un dispositif 100A, 100B, ou 100C. Le circuit comparateur 201 est adapté à recevoir en entrée les sorties 103OUTA, 103OUTB, et 103OUTC de toutes les chaînes de test 103A, 103B, et 103C des dispositifs 100A, 100B, et 100C, et à fournir en sortie autant de signaux que le nombre de jeu de chaînes de test 103A, 103B, 103C analogues. Dans le cas illustré en figure 2, le circuit comparateur 201 comprend six entrées 201IN et deux sorties 201OUT.

Le dispositif de comparaison 200 comprend, en outre, autant de boucles de rétroaction 203 que de chaînes de test dans un dispositif 100A, 100B, ou 100C. Chaque boucle de rétroaction 203 relie une sortie 201OUT du circuit comparateur 201 à une entrée 103INA, 103INB, 103INC d'une chaîne de test 103A, 103B, 103C. De plus, chaque boucle de rétroaction 203 relie une sortie 201OUT à une entrée 103INA, respectivement 103INB, 103INC, par l'intermédiaire, par exemple, d'un multiplexeur 210A, respectivement 210B, 210C. Chaque multiplexeur 210A, 210B, 210C, comprend au moins deux entrées, l'une reliée à une des boucles de rétroaction 203, et l'autre recevant un signal SCAN-IN, et comprend au moins une sortie reliée à une entrée 103INA, 103INB, 103INC, d'une chaîne de test 103A, 103B, 103C. Chaque boucle de rétroaction 203 relie, de plus, par l'intermédiaire des multiplexeurs 210A, 210B, 210C, toutes les entrées 103INA, 103INB, 103INC, des chaînes de test 103A, 103B, 103C analogues des dispositifs 100A, 100B, 100C. Les multiplexeurs 210A, 210B, et 210C, sont utilisés pour distinguer des données provenant des boucles de rétroaction 203 pendant une phase de test, et d'autres données utilisées pendant d'autres phases de test utilisant des protocoles de test différents que celui du présent mode de réalisation.

Le fonctionnement du dispositif 200 sera décrit en relation avec la figure 3.

La figure 3 est un organigramme 300 illustrant le fonctionnement du dispositif 200 de la figure 2.

A une étape 301 (PUSH DATA), toutes les données de test contenues dans les points de test 101A, 101B, 101C, sont déplacées vers le point de test 101A, 101B, 101C suivant dans leur chaîne de test 103A, 103B, 103C respective. Les données de test stockées dans le dernier point de test 101A, 101B, 101C, de toutes les chaînes de test 103A, 103B, 103C, sont envoyées sur les entrées 201IN du circuit comparateur 201.

A une étape 302 (COMPDATA3), le circuit comparateur 201 compare les données qu'il a reçues entre elles. Plus particulièrement, le circuit comparateur 201 compare entre elles des données des dispositifs 100A, 100B, 100C venant de chaînes de test 103A, 103B, 103C, analogues. Autrement dit, le circuit comparateur 201 compare entre elles trois données qui devraient être identiques.

A une étape 303 (Error ?), le circuit comparateur 201 détecte si une des trois données d'un jeu de chaînes de test 103A, 103B, 103C analogues qu'il compare est différente des deux autres.

Si les trois données sont identiques (Sortie N), l'étape suivante est l'étape 301. Le circuit comparateur 201 compare alors les données de test suivantes des chaînes de test 103A, 103B, 103C.

Si une des trois données, notée donnée A, est différente des deux autres, notées données B et C, (sortie Y), l'étape suivante est une étape 304 (COMPDATA2). Le dispositif 100A est alors considéré comme étant fautif et ne sera plus utilisé pendant la phase de test.

A l'étape 304, les données B et C sont comparées l'une à l'autre par le circuit comparateur 201.

A une étape 305 (Error ?), le circuit comparateur 201 détecte si les données B et C sont identiques ou différentes.

Si les données B et C sont différentes l'une de l'autre (sortie Y), cela signifie que les trois données A, B et C des dispositifs 100A, 100B, 100C sont différentes les unes des autres. Dans ce cas, l'étape suivante est une étape 306 (System Failure).

A l'étape 306, le dispositif 200 se met, par exemple, en défaut, et les dispositifs 100A, 100B et 100C cessent, par exemple, de fonctionner. A titre d'exemple, un rapport d'erreur peut être établi sur la base des données A, B, et C et peut être communiqué à une unité centrale ou à un utilisateur des dispositifs 103A, 103B, 103C.

Si les données B et C sont identiques (Sortie N), l'étape suivante est une étape optionnelle 307 (Corrupted ?) ou bien une étape 309 (RECOVER).

A l'étape optionnelle 307, le circuit comparateur 201 établit, par exemple, si l'un des dispositifs 100A, 100B, 100C est défectueux ou corrompu, par exemple, en fonction des données A, B, et C. Cette étape optionnelle 307 est, plus particulièrement, ajoutée si les points de test des dispositifs 100A, 100B, et 100C ne sont pas formés par des bascules, à titre d'exemple, lorsque les dispositifs sont des mémoires de type SRAM (Static Random Access Memory) ou DRAM (Dynamic Random Access Memory).

Si un ou plusieurs des dispositifs 100A, 100B, 100C, sont reconnus défectueux ou corrompus (SORTIE Y), l'étape suivante est une étape 310 (REBOOT) dans laquelle le ou les dispositifs concernés sont, par exemple, réinitialisés. En effet, les données de test peuvent être un mot binaire, ou une signature, signalant un disfonctionnement d'un des dispositifs 100A, 100B et 100C.

Si les dispositifs 100A, 100B, 100C, ne sont pas reconnus défectueux (Sortie N) alors l'étape suivante est l'étape 309.

A l'étape 309, le circuit comparateur 201 fournit en sortie une donnée de sortie S égale aux données B et C identiques. Cette donnée de sortie S est considérée comme la donnée correcte par lequel la donnée A du dernier point de test 101A de la chaîne 103A doit être remplacée. La donnée S est envoyée, par la boucle de rétroaction 203 appropriée, et écrite dans les premiers points de test 101A, 101B, et 101C des chaînes de tests 103A, 103B, 103C d'où proviennent les données A, B, et C. La donnée de test A incorrecte est alors corrigée.

L'étape suivante à l'étape 309 est une étape 311 identique à l'étape 301 décrit ci-dessus. Plus précisément, à l'étape 311, toutes les données de test contenues dans les points de test 101A, 101B, 101C, sont déplacées vers le point de test 101A, 101B, 101C suivant dans leur chaîne de test 103A, 103B, 103C respective. L'étape 311 est suivie de l'étape 304 décrite ci-dessus. En effet, le dispositif 100A ayant été reconnue fautif, seules les données des dispositifs 100B et 100C sont comparées. Le procédé de comparaison se répète jusqu'à ce que toutes les données de test de toutes les chaînes de test 103B et 103C soient comparées et jusqu'à ce que toutes les données de test de toutes les chaînes de test 103A soient corrigées.

Un avantage du procédé de détection et de correction d'erreur et du dispositif le mettant en oeuvre, décrits en relation avec les figures 2 et 3, est qu'ils peuvent être appliqués à n'importe quel dispositif du type du dispositif 100 décrit en relation avec la figure 1, indépendamment de son fonctionnement.

Un autre avantage du procédé et du dispositif des figures 2 et 3, est qu'ils permettent de détecter différents types d'erreurs. Plus particulièrement, ils permettent de détecter les erreurs sans observer le fonctionnement des dispositifs 100A, 100B, 100C ou le fonctionnement global du système dont ils font partie. Le dispositif de détection 200 permet donc également de détecter aussi bien les erreurs (SPF, Single Point Fault) ayant une influence directe sur le fonctionnement, que les erreurs (LFM, Latent Fault Metric) qui n'ont pas d'influence immédiate sur le fonctionnement des dispositifs 100A, 100B, et 100C.

Un autre avantage est que le dispositif de comparaison 200 ne nécessite pas la mise en oeuvre d'une mémoire stockant toutes les données de test des chaînes de test 103A, 103B, 103C des dispositifs 100A, 100B, 100C pour les comparer entre elles.

Un autre avantage du dispositif de comparaison 200 est qu'il est facile à mettre en oeuvre dans un système comprenant des dispositifs électroniques du type du dispositif 100 décrit en relation avec la figure 1, puisqu'il ne comprend qu'un circuit de comparaison, des boucles de rétroaction et des multiplexeurs.

Divers modes de réalisation et variantes ont été décrits. L'homme de l'art comprendra que certaines caractéristiques de ces divers modes de réalisation et variantes pourraient être combinées, et d'autres variantes apparaîtront à l'homme de l'art. En particulier, le dispositif de détection et de correction d'erreurs 200 pourrait être adapté pour comparer plus de trois dispositifs du type du dispositif 100 décrit en relation avec la figure 1.

Enfin, la mise en oeuvre pratique des modes de réalisation et variantes décrits est à la portée de l'homme du métier à partir des indications fonctionnelles données ci-dessus.

## Revendications

1. Procédé de détection et de correction d'erreurs comprenant la comparaison d'au moins trois dispositifs (100A, 100B, 100C) identiques comprenant chacun au moins une chaîne (103A, 103B, 103C) de données de test, chaque donnée de test étant stockée dans un point de test (101A, 101B, 101C), les points de test étant disposés dans le dispositif dès sa conception et la donnée de test stockée étant une donnée donnant une indication sur l'état du ou des composants auxquels le point de test est rattaché, le procédé comprenant les étapes suivantes :
(a) les données de test en dernière position dans ladite chaîne (103A, 103B, 103C) desdits au moins trois dispositifs (100A, 100B, 100C) sont comparées ;
(b) les autres données de test sont avancées d'une position dans leur chaîne (103A, 103B, 103C) ; et
(c) le résultat de la comparaison de l'étape (a) est écrit en première position dans ladite chaîne (103A, 103B, 103C),
les étapes (a), (b), et (c) sont répétées jusqu'à ce que toutes les données de test desdites chaînes (103A, 103B, 103C) sont comparées.

2. Procédé selon la revendication 1, dans lequel les points de test (101A, 101B, 101C) sont des registres ou des bascules.

3. Procédé selon la revendication 1 ou 2, dans lequel les données de test sont des mots binaires.

4. Procédé selon l'une quelconque des revendications 1 à 3, dans lequel les données de test sont tous des mots binaires de même taille.

5. Procédé selon l'une quelconque des revendications 1 à 3, dans lequel les données de test sont des mots binaires de taille différente.

6. Procédé selon l'une quelconque des revendications 1 à 5, dans lequel les dispositifs (100A, 100B, 100C) comprennent au moins deux chaînes de données de test.

7. Procédé selon l'une quelconque des revendications 1 à 6, de comparaison de plus de trois dispositifs électroniques identiques.

8. Dispositif de comparaison adapté à mettre en oeuvre le procédé selon l'une quelconque des revendications 1 à 7.

9. Dispositif selon la revendication 8 d'au moins trois dispositifs électroniques identiques (100A, 100B, 100C) comprenant chacun au moins une chaîne (103A, 103B, 103C) de données de test, comprenant :
- un circuit comparateur (201) ; et
- au moins trois boucles de rétroaction (203) reliant chacune une sortie (201OUT) du circuit comparateur (201) et une entrée (103INA, 103INB, 103INC) d'une desdites chaînes (103A, 103B, 103C).

10. Dispositif selon la revendication 9, dans lequel chaque boucle de rétroaction (203) relie une sortie (201OUT) du circuit comparateur (201) et une entrée (103INA, 103INB, 103INC) d'une desdites chaînes (103A, 103B, 103C) par l'intermédiaire d'un multiplexeur (210A, 210B, 210C).

11. Système électronique comprenant :
- au moins trois dispositifs électroniques (100A, 100B, 100C) identiques comprenant chacun au moins une chaîne (103A, 103B, 103C) de données de test ; et
- un dispositif de comparaison (201) selon l'une quelconque des revendications 8 à 10.

## Patentansprüche

1. Ein Verfahren zur Fehlererkennung und -korrektur, das Vergleichen von mindestens drei identischen Einrichtungen (100A, 100B, 100C) aufweist, von denen jede mindestens eine Kette (103A, 103B, 103C) aus Testdaten aufweist, wobei jedes Testdaten-Element in einem Testpunkt (101A, 101B, 101C) gespeichert ist, wobei Testpunkte in der Einrichtung vom Zeitpunkt der Konzeption an angeordnet sind und die gespeicherten Testdaten Daten sind, die einen Hinweis auf den Zustand der einen oder der mehreren Komponenten geben, an denen der Testpunkt angebracht ist, wobei das Verfahren die folgenden Schritte aufweist:
(a) die Testdaten in der letzten Position in der Kette (103A, 103B, 103C) der mindestens drei Einrichtungen (100A, 100B, 100C) werden verglichen;
(b) die anderen Testdaten werden in ihrer Kette (103A, 103B, 103C) um eine Position nach vorne verschoben;
(c) das Ergebnis des Vergleichs von Schritt (a) wird in die erste Position in der Kette (103A, 103B, 103C) geschrieben,
die Schritte (a), (b) und (c) werden wiederholt, bis alle Testdaten der Ketten (103A, 103B, 103C) verglichen sind.

2. Das Verfahren nach Anspruch 1, wobei die Testpunkte (101A, 101B, 101C) Register oder Flipflops sind.

3. Das Verfahren nach Anspruch 1 oder 2, wobei die Testdaten binäre Wörter sind.

4. Das Verfahren nach einem der Ansprüche 1 bis 3, wobei die Testdaten alle binäre Wörter mit gleicher Größe sind.

5. Das Verfahren nach einem der Ansprüche 1 bis 3, wobei die Testdaten binäre Wörter unterschiedlicher Größe sind.

6. Das Verfahren nach einem der Ansprüche 1 bis 5, wobei die Einrichtungen (100A, 100B, 100C) jeweils mindestens zwei Ketten aus Testdaten aufweisen.

7. Das Verfahren nach einem der Ansprüche 1 bis 6 zum Vergleich von mehr als drei identischen elektronischen Einrichtungen.

8. Eine Einrichtung, die angepasst ist, um das Verfahren nach einem der Ansprüche 1 bis 7 auszuführen.

9. Die Einrichtung nach Anspruch 8 zum Vergleich von mindestens drei identischen elektronischen Einrichtungen (100A, 100B, 100C), die jeweils mindestens eine Kette (103A, 103B, 103C) aus Testdaten aufweisen, wobei die Einrichtung Folgendes aufweist:
- eine Komparatorschaltung (201); und
- mindestens drei Rückkopplungsschleifen (203), die jeweils einen Ausgang (2010UT) der Komparatorschaltung (201) und einen Eingang (103INA, 103INB, 103INC) einer der Testketten (103A, 103B, 103C) koppeln.

10. Die Einrichtung nach Anspruch 9, wobei jede Rückkopplungsschleife (203) einen Ausgang (201OUT) der Komparatorschaltung (201) und einen Eingang (103INA, 103INB, 103INC) einer der Ketten (103A, 103B, 103C) über einen Multiplexer (210A, 210B, 210C) koppelt.

11. Ein elektronisches System, das Folgendes aufweist:
- mindestens drei identische elektronische Einrichtungen (100A, 100B, 100C), die jeweils mindestens eine Kette (103A, 103B, 103C) aus Testdaten aufweisen, und die Folgendes aufweisen:
- die Einrichtung (201) nach einem der Ansprüche 8 bis 10.

## Claims

1. An error detection and correction method comprising comparing at least three identical devices (100A, 100B, 100C), each comprising at least one chain (103A, 103B, 103C) of test data, each piece of test data is stored in a test point (101A, 101B, 101C), test points being arranged in the device from the moment of conception and the stored test data being a data giving a indication about the state of the one or the several components to which the test point is attached, the method comprising the following steps:
(a) the test data in the last position in said chain (103A, 103B, 103C) of said at least three devices (100A, 100B, 100C) are compared;
(b) the other test data are shifted forward by one position in their chain (103A, 103B, 103C);
(c) the result of the comparison of step (a) is written in the first position in said chain (103A, 103B, 103C),
steps (a), (b), and (c) are repeated until all the test data of said chains (103A, 103B, 103C) are compared.

2. The method of claim 1, wherein the test points (101A, 101B, 101C) are registers or flip-flops.

3. The method of claim 1 or 2, wherein the test data are binary words.

4. The method of any of claims 1 to 3, wherein the test data all are binary words of same size.

5. The method of any of claims 1 to 3, wherein the test data are binary words of different sizes.

6. The method of any of claims 1 to 5, wherein the devices (100A, 100B, 100C) each comprise at least two chains of test data.

7. The method any of claims 1 to 6, of comparison of more than three identical electronic devices.

8. A device of comparison adapted to execute the method of any of claims 1 to 7.

9. The device of claim 8, of comparison of at least three identical electronic devices (100A, 100B, 100C) each comprising at least one chain (103A, 103B, 103C) of test data, comprising:
- a comparator circuit (201); and
- at least three feedback loops (203), each coupling an output (201OUT) of the comparator circuit (201) and an input (103INA, 103INB, 103INC) of one of said test chains (103A, 103B, 103C).

10. The device of claim 9, wherein each feedback loop (203) couples an output (201OUT) of the comparator circuit (201) and an input (103INA, 103INB, 103INC) of one of said chains (103A, 103B, 103C) via a multiplexer (210A, 210B, 210C).

11. An electronic system comprising:
- at least three identical electronic devices (100A, 100B, 100C), each comprising at least one chain (103A, 103B, 103C) of test data, comprising:
- the comparison device (201) any of claims 8 to 10.
